(19) Europäisches Patentamt
European Patent Office
Office européen des brevets

(11) **EP 4 467 683 A1**

(12) **EUROPEAN PATENT APPLICATION**
published in accordance with Art. 153(4) EPC

(43) Date of publication:
**27.11.2024 Bulletin 2024/48**

(21) Application number: **23743213.3**

(22) Date of filing: **16.01.2023**

(51) International Patent Classification (IPC):
*C23C 16/448* (2006.01)     *B01J 4/00* (2006.01)
*B01J 7/00* (2006.01)     *H01L 21/205* (2006.01)

(52) Cooperative Patent Classification (CPC):
**B01J 4/00; B01J 7/00; C23C 16/448; H01L 21/2015**

(86) International application number:
**PCT/JP2023/000987**

(87) International publication number:
**WO 2023/140219 (27.07.2023 Gazette 2023/30)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **21.01.2022 JP 2022008099**

(71) Applicant: **L'AIR LIQUIDE, SOCIETE ANONYME POUR L'ETUDE ET L'EXPLOITATION DES PROCEDES GEORGES CLAUDE**
**75007 Paris (FR)**

(72) Inventors:
• **GOTO, Mikio**
  **Tokyo 108-8509 (JP)**
• **NAKAGAWA, Toshiyuki**
  **Tokyo 108-8509 (JP)**
• **IDA, Kentaro**
  **Tokyo 108-8509 (JP)**

(74) Representative: **Air Liquide**
**L'Air Liquide S.A.**
**Direction de la Propriété Intellectuelle**
**75, Quai d'Orsay**
**75321 Paris Cedex 07 (FR)**

(54) **SOLID MATERIAL REMAINING AMOUNT MEASUREMENT METHOD, SUBLIMATED GAS SUPPLY METHOD, AND SUBLIMATED GAS SUPPLY SYSTEM**

(57)     [Problem] To provide a measuring method capable of suppressing loss of a residual quantity of a solid material inside a solid material vessel when a sublimation gas of the solid material is supplied to a subsequent process.

[Solution] The method comprises, when a buffer tank is refilled with a sublimation gas: a first residual quantity calculation step in which a residual quantity of the solid material is calculated from a consumption amount of the sublimation gas fed from the buffer tank to the subsequent process; a second residual quantity calculation step in which the residual quantity of the solid material is calculated from a mass amount of the sublimation gas fed from a solid material vessel to the buffer tank; and/or a switching determination step in which a switching timing and an abnormality are determined from the residual quantity of the solid material inside the solid material vessel.

[Fig. 1]

**Description**

[Technical Field]

The present disclosure relates to a method for measuring a residual quantity of a solid material inside a solid material vessel, a sublimation gas supply method, and a sublimation gas supply system, for when a sublimation gas of a solid material is supplied to a subsequent process.

[Background Art]

A semiconductor production process comprises multiple processes, and a film-forming process is needed in order to produce a semiconductor integrated device. In a film-forming step, a plurality of layers including an insulating material and a conductive material for forming a semiconductor element are formed in a layered form to impart functions. The film-forming process varies according to the type of material and the structure. For example, ALD (atomic layer deposition) is a method in which an extremely thin film is formed by laminating layers of several atoms.

A feature of ALD (atomic layer deposition) lies in the fact that single steps appropriately controlled in succession are repeated. In a first step, a wafer is covered by a precursor. In a second step a precursor gas inside a reaction chamber is purged with an inert gas (e.g., argon or nitrogen). In a third step, an oxidizing agent or a reducing agent gas is introduced and reacted with the precursor, and the desired material is formed on a wafer surface. In a fourth step, the oxidizing agent or reducing agent gas inside the reaction chamber is purged with an inert gas (e.g., argon or nitrogen). Atomic layer deposition comprises the steps above, and therefore has a feature in that consumption of each substance progresses intermittently. Therefore, the precursor gas is consumed in only one of the four steps. By utilizing this feature, a buffer vessel can be refilled with the precursor gas as the other processes, following use of the precursor, progress. Furthermore, CVD (chemical vapor deposition) also exists in addition to ALD as a film-forming process employing a gas. Furthermore, dry etching for forming a circuit exists as a gas-employing process other than the film-forming process.

Examples of precursors used for film formation which may be mentioned include inorganic compounds and organometallic compounds, etc. of aluminum, barium, bismuth, chromium, cobalt, copper, gold, hafnium, indium, iridium, iron, lanthanum, lead, magnesium, molybdenum, nickel, niobium, platinum, ruthenium, silver, strontium, tantalum, titanium, tungsten, yttrium and zirconium. These materials have a low vapor pressure and therefore need to be sublimed for supply in the case of a solid material for introduction into the reaction chamber. In a conventional method, a starting material powder is contained in a vapor generating chamber, the starting material powder is heated to generate saturated vapor, and a carrier gas is brought into contact with the starting material vapor to obtain a carrier gas containing the starting material powder, which is then supplied to a film-forming apparatus (e.g., see Patent Document 1).

Patent Document 2 indicates that a sublimation gas is fed into a buffer tank from a solid material vessel and stored therein for a time, then supplied to a subsequent process. The buffer tank is refilled from a solid material vessel with the gas consumed as a result of being supplied to the subsequent process.

ALD is a technology which is needed in order to produce smaller and more intricate semiconductor devices. However, progress in the semiconductor industry has increased the quantity of materials having a low vapor pressure which are used for film formation, etc. A low vapor pressure makes it necessary to cause sublimation of the solid materials before introduction into the film-forming chamber. The temperature of the gas duct (piping) needs to be kept higher than the sublimation point of the solid material. The semiconductor production process is complex, and an adverse effect in one process affects all of the other processes. That is to say, interruption of a process is directly related to delaying the process as a whole. Accordingly, continuous supply of the solid material to the semiconductor production apparatus is an important component for maintaining throughput. Furthermore, customers require costs to be reduced by stretching the quantity of material used to the limit. Meanwhile, if the residual quantity of solid material decreases beyond a supply limit so that the supply of the starting material to the semiconductor production apparatus is interrupted, this causes considerable damage to wafers.

The following problems are encountered in the management of the residual quantity of solid material in the semiconductor production process.

1) The solid material vessel is formed by a metal material so the inside of the vessel cannot be directly seen.
2) It is difficult to perform an accurate weight measurement using a load cell (weight gauge). This is because the solid material vessel is connected to the gas duct and both the gas duct and the vessel are heated.
3) A method for calculating a cumulative flow rate using a mass flow controller may produce large cumulative errors due to integration. Furthermore, it may not be possible to use a mass flow controller for reasons of equipment cost, temperature and space, etc. Additionally, abnormalities in the process line cannot be accurately judged simply by detecting a reduction in the starting material gas pressure. In order to solve these problems, it would therefore be desirable to develop a novel method for measuring the residual quantity.

[Prior Art Documents]

[Patent Documents]

[Patent Document 1] JP H3-141192 A
[Patent Document 2] WO 2021/067764 A1

[Summary of the Invention]

[Problems to be Solved by the Invention]

The objective of the present disclosure lies in providing a method for measuring, with high precision, a residual quantity of a solid material inside a solid material vessel, a sublimation gas supply method, and a sublimation gas supply system, for when a sublimation gas of a solid material is supplied to a subsequent process.

[Means for Solving the Problems]

A first sublimation gas supply system may comprise:

a first solid material vessel (1A) in which a solid material is accommodated;
a second solid material vessel (1B) in which a solid material is accommodated; sublimation gas piping (5) which is formed by merging of first and second branch pipes (3A, 3B) leading out from each of the first and second solid material vessels (1A, 1B);
a buffer tank (13) connected to the sublimation gas piping (5);
an introduction pipe (14) for introducing the sublimation gas from the buffer tank (13) to a subsequent process (e.g., a chamber);
a first pressure measuring means (4) provided in the sublimation gas piping (5) (or equally in the first and second branch pipes (3A, 3B);
a first branch valve (2A) provided between the first solid material vessel (1A) and the first pressure measuring means (4) (or in the first branch pipe (3A));
a second branch valve (2B) provided between the second solid material vessel (1B) and the first pressure measuring means (4) (or in the second branch pipe (3B));
a second valve (10) provided between the first pressure measuring means (4) and the buffer tank (13);
a third valve (15) provided in the introduction pipe (14);
a second pressure measuring means (11) provided between the second valve (10) and the third valve (15) (or equally provided directly in the buffer tank (13)); and
a first residual quantity calculation unit (121) for calculating a residual quantity of the solid material from a consumption amount of the sublimation gas fed from the buffer tank (13) to the subsequent process.

The first sublimation gas supply system may further comprise a second residual quantity calculation unit (122) for calculating the residual quantity of the solid material from a mass amount of the sublimation gas fed from the first and second solid material vessels to the buffer tank (13).

The first sublimation gas supply system may further comprise a first switching determination unit (131) for determining a switching timing and an abnormality from the residual quantity of the solid material inside the first and second solid material vessels.

The first residual quantity calculation unit (121):

may calculate a consumption amount (Consumption $_1$) of the sublimation gas fed from the buffer tank (13) from: a first differential pressure $\Delta P_1$ between a pressure ($P_{open}$) inside the buffer tank (13) before opening of the third valve (15) in a state in which the sublimation gas is stored in the buffer tank (13), and a pressure ($P_{close}$) inside the buffer tank (13) when the third valve has been closed after the sublimation gas has been fed from the buffer tank (13) to the subsequent process, the volume ($V_{buffer}$) of the buffer tank (13), the density (d) of the sublimation gas, and a first correction factor ($C_1$); and may calculate a first residual quantity ($W_{r1}$) of the solid material accommodated in the solid material vessel by subtracting the total quantity of the calculated first consumption amount (Consumption $_1$) from an initial weight ($W_0$) of the solid material accommodated in the solid material vessel currently supplying the sublimation gas to the buffer tank.

In "a pressure ($P_{open}$) inside the buffer tank (13) before opening of the third valve (15)", the phrase "before opening of the third valve (15)" means immediately before opening of the third valve (15), for example. It should be noted that "immediately before" means before the sublimation gas supply system receives a signal from the subsequent process (e.g., a film-forming apparatus) and sends an opening signal to the third valve (15) of a sublimation gas supply apparatus.

The second residual quantity calculation unit (122):

may calculate a consumption amount ($Consumption_2$) of the sublimation gas fed from the buffer tank (13) from: a second differential pressure $\Delta P_2$ between a pressure ($P_{close\_1}$) inside the buffer tank (13) in a state in which the third valve (15) is closed, and a pressure ($P_{full}$) when the sublimation gas has been fed to the buffer tank (13) from either solid material vessel and the pressure inside the buffer tank (13) has reached a set pressure (first threshold ($Th_1$)), the volume ($V_{buffer}$) of the buffer tank (13), the density (d) of the sublimation gas, and a second correction factor ($C_2$); and may calculate a second residual quantity ($W_{r2}$) of the solid material accommodated in the solid material vessel by subtracting the total quantity of the calculated second consumption amount ($Consumption_2$) from an initial weight ($W_0$) of the solid material accommodated in the solid material vessel currently supplying the sublimation gas to the buffer tank.

The first switching determination unit (131):

when the sublimation gas is fed from either solid material vessel to the buffer tank (13), if the pressure inside the buffer tank (13) does not exceed a first threshold ($Th_1$) within a preset period, may determine whether or not a pressure value inside the solid material vessel has decreased from a pressure value when a second valve (10) was open (e.g., a predetermined value or more, within values in a predetermined range, or a pressure of 10% or greater or 20% or greater), or may determine whether or not the pressure value inside the solid material vessel exceeds a second threshold ($Th_2$), and if the pressure value inside the solid material vessel has not decreased from the pressure value when the second valve (10) was open or the pressure value inside the solid material vessel exceeds the second threshold ($Th_2$), may determine that there is an abnormality in the sublimation gas piping (5) downstream of the first pressure measuring means (4), and if the pressure value inside the solid material vessel has decreased from the pressure value when the second valve (10) was open or the pressure value inside the solid material vessel does not exceed the second threshold ($Th_2$), may determine whether or not a latest first residual quantity ($W_{r1}$), a latest second residual quantity ($W_{r2}$), or an average value or a weighted average value of both thereof is smaller than a third threshold ($Th_3$), and if the latest first residual quantity ($W_{r1}$), the latest second residual quantity ($W_{r2}$), or the average value or the weighted average value of both thereof is not smaller than the third threshold ($Th_3$), may determine that there is an abnormality in the sublimation gas piping (5) or any branch pipe upstream of the first pressure measuring means (4), and if the latest first residual quantity ($W_{r1}$), the latest second residual quantity ($W_{r2}$), or the average value or the weighted average value of both thereof is smaller than the third threshold ($Th_3$), may determine that there should be a switch to a different solid material vessel from the abovementioned solid material vessel.

A "pressure value when the second valve (10) was open" is a pressure measured by the first pressure measuring means (4), for example.

A second sublimation gas supply system may comprise:

a first solid material vessel (1A) in which a solid material is accommodated;

a second solid material vessel (1B) in which a solid material is accommodated;

sublimation gas piping (5) which is formed by merging of first and second branch pipes (3A, 3B) leading out from each of the first and second solid material vessels (1A, 1B);

a buffer tank (13) connected to the sublimation gas piping (5);

an introduction pipe (14) for introducing the sublimation gas from the buffer tank (13) to a subsequent process (e.g., a chamber);

third and fourth pressure measuring means (4A, 4B) respectively provided in the first and second solid material vessels (1A, 1B);

a first branch valve (2A) provided in the first branch pipe (3A);

a second branch valve (2B) provided in the second branch pipe (3B);

a second valve (10) provided in the sublimation gas piping (5);

a third valve (15) provided in the introduction pipe (14);

a second pressure measuring means (11) provided between the second valve (10) and the third valve (15) (or equally provided directly in the buffer tank (13)); and

a first residual quantity calculation unit (121) for calculating a residual quantity of the solid material from a consumption amount of the sublimation gas fed from the buffer tank (13) to the subsequent process.

The first sublimation gas supply system may further comprise a second residual quantity calculation unit (122) for calculating the residual quantity of the solid material from a mass amount of the sublimation gas fed from the first and second solid material vessels to the buffer tank (13).

The second sublimation gas supply system may further comprise a second switching determination unit (132) for determining a switching timing and an abnormality from the residual quantity of the solid material inside the first and second solid material vessels.

The second switching determination unit (132):

when the sublimation gas is fed from either solid material vessel to the buffer tank (13), if the pressure inside the buffer tank (13) does not exceed a first threshold ($Th_1$) within a preset period, may determine whether or not a pressure value inside the solid material vessel has decreased from a pressure value when the second valve (10) was open (e.g., a predetermined value or more, within values in a predetermined range, or a pressure of 10% or greater or 20% or greater), or may determine whether or not the pressure value inside the solid material vessel exceeds a second threshold ($Th_2$), and if the pressure value inside the solid material vessel has not decreased from the pressure value when the valve (10) was open or the pressure value inside the solid material vessel exceeds the second threshold ($Th_2$), may determine that there is an abnormality in a branch pipe or the sublimation gas piping (5) downstream of the solid material vessel, and if the pressure value inside the solid material vessel has decreased from the pressure value when the second valve (10) was open or the pressure value inside the solid material vessel does not exceed the second threshold ($Th_2$), may determine that there should be a switch to a different solid material vessel from the abovementioned solid material vessel.

A third sublimation gas supply system may comprise:

   at least two solid material vessels (1A, 1B, 1C) in which a solid material is accommodated;
   sublimation gas piping (5) which is formed by merging of branch pipes (3A, 3B, 3C) leading out from each of the solid material vessels;
   at least one buffer tank (13A, 13B) connected to the sublimation gas piping (5);
   at least one introduction pipe (14A, 14B) for introducing the sublimation gas from the at least one buffer tank (13A, 13B) to at least one subsequent process (chambers RA, RB);
   a first pressure measuring means (4 (4A, 4B, 4C)) provided in the sublimation gas piping (5) (or equally provided in each of the branch pipes (3A, 3B, 3C));
   a first valve provided between the solid material vessels (1A, 1B, 1C) and the first pressure measuring means (4) (or branch valves (2A, 2B, 2C) provided in each branch pipe);
   at least one second valve (10A, 10B) provided between the first pressure measuring means (4) and the at least one buffer tank (13A, 13B) (or in each branch pipe (15A, 15B) branching from the sublimation gas piping (5) to each buffer tank);
   at least one third valve (15A, 15B) provided in the introduction pipe (14A, 14B);
   a second pressure measuring means (11A, 11B) provided between the second valve (10A, 10B) and the third valve (15A, 15B) (or equally provided directly in the buffer tank (13A, 13B)); and
   a first residual quantity calculation unit (121) for calculating a residual quantity of the solid material from a consumption amount of the sublimation gas fed from the buffer tank (13A, 13B) to the subsequent process (chambers RA, RB).

The third sublimation gas supply system may further comprise a second residual quantity calculation unit (122) for calculating the residual quantity of the solid material from a mass amount of the sublimation gas fed from the solid material vessel to the buffer tank (13A, 13B).

The third sublimation gas supply system may further comprise a first switching determination unit (131) for determining a switching timing and an abnormality from the residual quantity of the solid material inside the solid material vessel.

Furthermore, when the pressure measuring means (4A, 4B, 4C) are provided in each of the solid material vessels (1A, 1B, 1C) and the branch valves (2A, 2B, 2C) are provided in the branch pipes (3A, 3B, 3C), the third sublimation gas supply system may comprise a second switching determination unit (132) for determining a switching timing and an abnormality from the residual quantity of the solid material inside the solid material vessels.

The first, second and third sublimation gas supply systems may be incorporated into an ALD apparatus, a CVD apparatus, and an etching apparatus, etc.

A sublimation supply method comprises:

   a supply step in which a sublimation gas is supplied from a buffer tank to a subsequent process;
   a supply stop step in which the supply of the sublimation gas from the buffer tank to the subsequent process is stopped; and
   a sublimation gas refill step in which the buffer tank is refilled with the sublimation gas during the supply stop step.

The sublimation gas refill step comprises:

   a first residual quantity calculation step in which a residual quantity of the solid material is calculated from a consumption amount of the sublimation gas fed from the buffer tank to the subsequent process;
   a second residual quantity calculation step in which the residual quantity of the solid material is calculated from a mass amount of the sublimation gas fed from a solid material vessel to the buffer tank; and/or
   a switching determination step in which a switching timing and an abnormality are determined from the residual quantity of the solid material inside the solid material vessel.

In the first residual quantity calculation step:
a first consumption amount (Consumption $_1$) of the sublimation gas fed from the buffer tank (13) may be calculated from: a first differential pressure $\Delta P_1$ with a pressure ($P_{close}$) inside the buffer tank (13) before opening of the third valve (15) for feeding to the subsequent process in a state in which the sublimation gas is stored in the buffer tank (13), the volume ($V_{buffer}$) of the buffer tank (13), the density (d) of the sublimation gas, and a first correction factor ($C_1$); and a first residual quantity ($W_{r1}$) of the solid material accommodated in the solid material vessel may be calculated by subtracting the total quantity of the calculated first consumption amount (Consumption $_1$) from an initial weight ($W_0$) of the solid material accommodated in the solid material vessel currently supplying the sublimation gas to the buffer tank.

In "a pressure ($P_{close}$) inside the buffer tank (13) before opening of the third valve (15)", the phrase "before opening of the third valve (15)" means immediately before opening of the third valve (15), for example. It should be noted that "immediately before" means before the sublimation gas supply system receives a signal from the subsequent process (e.g., a film-forming apparatus) and sends an opening signal to the third valve (15) of a sublimation gas supply apparatus.

In the second residual quantity calculation step:
a second consumption amount (Consumption $_2$) of the sublimation gas fed from the buffer tank (13) may be calculated from: a second differential pressure $\Delta P_2$ between a pressure ($P_{close\_1}$) inside the buffer tank (13) in a state in which the third valve (15) for feeding to the subsequent process is closed, and a pressure ($P_{full}$) when the sublimation gas has been fed to the buffer tank (13) from any solid material vessel and the pressure inside the buffer tank (13) has reached a set pressure, the volume ($V_{buffer}$) of the buffer tank (13), the density (d) of the sublimation gas, and a second correction factor ($C_2$); and a second residual quantity ($W_{r2}$) of the solid material accommodated in the solid material vessel may be calculated by subtracting the total quantity of the calculated second consumption amount (Consumption $_2$) from an initial weight ($W_0$) of the solid material accommodated in the solid material vessel currently supplying the sublimation gas to the buffer tank.

In the switching determination step:

when the sublimation gas is fed from any solid material vessel to the buffer tank (13) for feeding to the subsequent process, if the pressure inside the buffer tank (13) does not exceed a first threshold ($Th_1$) within a preset period, it may be determined whether or not a pressure value inside the solid material vessel has decreased from a pressure value when a second valve (10), which is arranged between the first pressure measuring means and the second pressure measuring means, was open (e.g., a predetermined value or more, within values in a predetermined range, or a pressure of 10% or greater or 20% or greater), or it may be determined whether or not the pressure value inside the solid material vessel exceeds a second threshold ($Th_2$), and if the pressure value inside the solid material vessel has not decreased from the pressure value when the second valve (10), which is arranged between the first pressure measuring means and the second pressure measuring means, was open or the pressure value inside the solid material vessel exceeds the second threshold ($Th_2$), it may be determined that there is an abnormality in the sublimation gas piping (5) downstream of the first pressure measuring means (4), and if the pressure value inside the solid material vessel has decreased from the pressure value when the second valve (10), which is arranged between the first pressure measuring means and the second pressure measuring means, was open or the pressure value inside the solid material vessel does not exceed the second threshold ($Th_2$), it may be determined whether or not a latest first residual quantity ($W_{r1}$), a latest second residual quantity ($W_{r2}$), or an average value or a weighted average value of both thereof is smaller than a third threshold ($Th_3$), and if the latest first residual quantity ($W_{r1}$), the latest second residual quantity ($W_{r2}$), or the average value or the weighted average value of both thereof is not smaller than the third threshold ($Th_3$), it may be determined that there is an abnormality in the sublimation gas piping (5) or any branch pipe upstream of the first pressure measuring means (4), and if the latest first residual quantity ($W_{r1}$), the latest second residual quantity ($W_{r2}$), or the average value or the weighted average value of both thereof is smaller than the third threshold ($Th_3$), it may be determined that there should be a switch to a different solid material vessel from the abovementioned solid material vessel.

In a different switching determination step:

when the sublimation gas is fed from any solid material vessel to the buffer tank (13), if the pressure inside the buffer tank (13) does not exceed a first threshold ($Th_1$) within a preset period, it may be determined whether or not a pressure value inside the solid material vessel has decreased from a pressure value when the second valve (10), which is arranged between the first pressure measuring means and the second pressure measuring means, was open (e.g., a predetermined value or more, within values in a predetermined range, or a pressure of 10% or greater or 20% or greater), or it may be determined whether or not the pressure value inside the solid material vessel exceeds a second threshold ($Th_2$), and if the pressure value inside the solid material vessel has not decreased from the pressure value when the valve (10), which is arranged between the first pressure measuring means and the second pressure measuring means, was open or the pressure value inside the solid material vessel exceeds the second threshold ($Th_2$), it may be determined that there is an abnormality in a branch pipe or the sublimation gas piping (5) downstream of the solid material vessel, and if the pressure value inside the solid material vessel has decreased from the pressure value when the second valve (10), which is arranged between the first pressure measuring means and the second pressure measuring means, was open or the pressure value inside the solid material vessel does not exceed the second threshold ($Th_2$), it may be determined that there should be a switch to a different solid material vessel from the abovementioned solid material vessel.

A residual quantity measuring method for measuring a residual quantity of a solid material inside a solid material vessel comprises, during sublimation gas refilling in which the buffer tank is refilled with a sublimation gas:

a first residual quantity calculation step in which a residual quantity of the solid material is calculated from a consumption amount of the sublimation gas fed from the buffer tank to the subsequent process;
a second residual quantity calculation step in which the residual quantity of the solid material is calculated from a mass amount of the sublimation gas fed from a solid material vessel to the buffer tank; and/or
a switching determination step in which a switching timing and an abnormality are determined from the residual quantity of the solid material inside the solid material vessel.

An information processing device may comprise:

at least one processor; and
a memory for storing commands for executing a residual quantity measuring method for measuring the residual quantity of the solid material inside the solid material vessel, or the abovementioned sublimation gas supply method, and
the processor may implement the residual quantity measuring method.

A residual quantity measuring or sublimation gas supply program constitutes:
a program for executing a residual quantity measuring method for measuring the residual quantity of the solid material inside the solid material vessel, or the abovementioned sublimation gas supply method, by means of the at least one processor.
A computer-readable recording medium for storing computer instructions constitutes:
a computer-readable recording medium for storing commands for executing a residual quantity measuring method for measuring the residual quantity of the solid material inside the solid material vessel, or the abovementioned sublimation gas supply method.
The first and second residual quantity calculation units, and the first and second switching determination units may be configured by an information processing device comprising a memory, a processor, and a software program (e.g., a computer or server), a dedicated circuit, firmware, etc. The information processing device may be on premises or in the cloud or a combination of both.
Examples of the pressure measuring means including the first and second pressure measuring means which may be cited include a Bourdon tube pressure gauge and a diaphragm pressure gauge, etc.
The sublimation gas supply system may comprise:

heating portions for heating the solid material vessels (1A, 1B, 1C);
heating portions for heating the buffer tanks (13, 13A, 13B);
means for heating or thermally insulating the sublimation gas piping (5), the introduction pipes (14, 14A, 14B), and the branch pipes (3A, 3B, 3C, 14A, 14B); and
means for heating or thermally insulating the branch valves (2A, 2B, 2C, 10A, 10B, 15A, 15B), and the second and third valves (10, 15).

By virtue of this configuration it is possible to prevent the sublimation gas from condensing and solidifying.

[Advantages]

It is possible to determine the residual amount inside the solid material vessel by calculating the consumption amount of the solid material without the use of a mass flow meter, a mass flow controller, or a load cell. This configuration enables use up to the supply limit of the solid material inside the solid material vessel. As a result, it is possible to reduce loss of the solid material which is the starting material. When there is a drop in supply pressure, it is possible to determine whether this is due to consumption of the solid material or due to an abnormality in the piping. The sublimation gas can be continuously supplied by switching the solid material vessel during normal consumption or an abnormality.

[Brief Description of the Drawings]

[Fig. 1] schematically shows a sublimation gas supply system according to embodiment 1.
[Fig. 2A] shows a flowchart of residual quantity measurement according to embodiment 1.
[Fig. 2B] shows a flowchart of different residual quantity measurement.
[Fig. 3] schematically shows an ALD apparatus comprising the sublimation gas supply system according to embodiment 1.
[Fig. 4] schematically shows a sublimation gas supply system according to embodiment 2.
[Fig. 5] shows a flowchart of residual quantity measurement according to embodiment 2.
[Fig. 6] schematically shows a sublimation gas supply system according to embodiment 3.
[Fig. 7] schematically shows a sublimation gas supply system according to embodiment 4.
[Fig. 8] shows a flowchart of residual quantity measurement according to embodiment 4.
[Fig. 9] schematically shows an ALD apparatus comprising the sublimation gas supply system according to embodiment 4.
[Fig. 10] schematically shows a sublimation gas supply system according to embodiment 5.
[Fig. 11] schematically shows a sublimation gas supply system according to embodiment 6 (a configuration incorporated into a CVD apparatus).
[Fig. 12] shows an operating flowchart according to embodiment 6.

[Embodiments of the Invention]

Several embodiments of the present invention will be described below. The embodiments described below are examples of the present invention. The present invention is in no way limited by the following embodiments, and also includes a number of variant modes which are implemented within a scope that does not alter the gist of the present invention. It should be noted that not all of the components described below are essential components of the present invention. In the present specification, the terms "upstream" and "downstream" are based on the flow of the sublimation gas in the sublimation gas supply system.

(Embodiment 1)

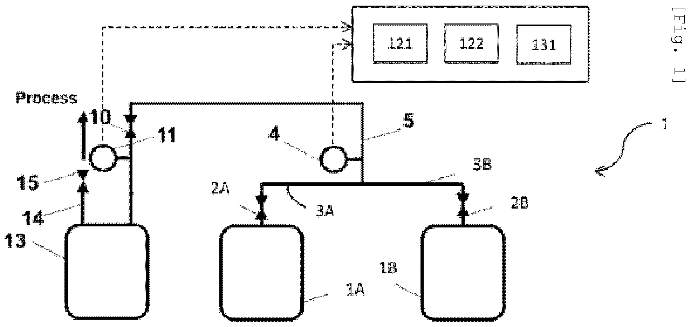

Fig. 1 schematically shows a first sublimation gas supply system.
The first sublimation gas supply system 1 comprises: a first solid material vessel 1A in which a predetermined quantity of a solid material is accommodated in advance; a second solid material vessel 1B in which a predetermined quantity of a solid material (the same solid material as that indicated above) is accommodated in advance; sublimation gas piping 5 which is formed by merging of first and second branch pipes 3A, 3B leading out from each of the first and second solid material vessels 1A, 1B; a buffer tank 13 connected to the sublimation gas piping 5; and an introduction pipe 14 for introducing a sublimation gas from the buffer tank 13 to a subsequent process (e.g., a chamber). The following are also provided: heating portions (electrical jackets) for heating the solid material vessels 1A, 1B; a heating portion (e.g., an electrical jacket) for heating the buffer tank 13; and means (e.g., a hot air heater or an electrical jacket) for heating or thermally insulating the sublimation gas piping 5, the introduction pipe 14, and the branch pipes 3A, 3B.
The first sublimation gas supply system 1 comprises: a first pressure measuring means 4 provided in the sublimation gas piping 5;
a first branch valve 2A provided in the first branch pipe 3A; a second branch valve 2B provided in the second branch valve 3B; a second valve 10 provided between the first pressure measuring means 4 and the buffer tank 13; a third valve 15 provided in the introduction pipe 14; and a second pressure measuring means 11 provided between the second valve 10 and the buffer tank 30.
The first sublimation gas supply system 1 comprises: a first residual quantity calculation unit 121 for calculating a residual quantity of the solid material from a consumption amount of the sublimation gas fed from the buffer tank 13 to the subsequent process; and a switching determination unit 131 for determining a switching timing and an abnormality from the residual quantity of the solid material inside the first and second solid material vessels.
A different embodiment further comprises a second residual quantity calculation unit 122 for calculating the residual quantity of the solid material from a mass amount of the sublimation gas from the first and second solid material vessels to the buffer tank 13.
The first residual quantity calculation unit 121 calculates a consumption amount (Consumption$_1$) of the sublimation gas fed from the buffer tank 13 from: a first differential pressure $\Delta P_1$ between a pressure $P_{open}$ inside the buffer tank 13 before opening of the third valve 15 (For example, "before opening of the third valve 15" means immediately before opening of the third valve 15. It should be noted that "immediately before" means before the sublimation gas supply system receives a signal from the subsequent process and sends an opening signal to the third valve 15 of a sublimation gas supply apparatus.) in a state in which the sublimation gas is stored in the buffer tank 13, and a pressure $P_{close}$ inside the buffer tank 13 when the third valve has been closed after the sublimation gas has been fed from the buffer tank 13 to the subsequent process, the volume $V_{buffer}$ of the buffer tank 13, the density d of the sublimation gas, and a first correction factor $C_1$; and

calculates a first residual quantity ($W_{r1}$) of the solid material accommodated in the solid material vessel by subtracting the total quantity of the calculated first consumption amount (Consumption $_1$) from an initial weight ($W_0$) of the solid material accommodated in the solid material vessel currently supplying the sublimation gas to the buffer tank.

The second residual quantity calculation unit 122 calculates a second consumption amount (Consumption $_2$) of the sublimation gas fed from the buffer tank 13 from: a second differential pressure $\Delta P_2$ between a pressure $P_{close\_1}$ inside the buffer tank 13 in a state in which the third valve 15 is closed, and a pressure $P_{full}$ when the sublimation gas has been fed to the buffer tank 13 from either solid material vessel which is refilling the buffer tank and the pressure inside the buffer tank 13 has reached a set pressure (first threshold ($Th_1$), the volume $V_{buffer}$ of the buffer tank, the density d of the sublimation gas, and a second correction factor $C_2$; and calculates a second residual quantity ($W_{r2}$) of the solid material accommodated in the solid material vessel by subtracting the total quantity of the calculated second consumption amount (Consumption $_2$) from an initial weight ($W_0$) of the solid material accommodated in the solid material vessel currently supplying the sublimation gas to the buffer tank.

When the sublimation gas is fed from either solid material vessel to the buffer tank 13, if the pressure inside the buffer tank 13 does not exceed a first threshold $Th_1$ within a preset period, the first switching determination unit 131 determines whether or not a pressure value inside the solid material vessel has decreased from a pressure value when the second valve 10 was open, e.g., a predetermined value or more, within values in a predetermined range, or a pressure of 10% or greater or 20% or greater, or determines whether or not the pressure value inside the solid material vessel exceeds a second threshold $Th_2$. If the pressure value inside the solid material vessel has not decreased from the pressure value when the second valve 10 was open or the pressure value inside the solid material vessel exceeds the second threshold $Th_2$, it is determined that there is an abnormality in the sublimation gas piping 5 downstream of the first pressure measuring means 4. If the pressure value inside the solid material vessel has decreased from the pressure value when the second valve 10 was open or the pressure value inside the solid material vessel does not exceed the second threshold $Th_2$, the first switching determination unit 131 determines whether or not a latest first residual quantity $W_{r1}$, a latest second residual quantity $W_{r2}$, or an average value or a weighted average value of both thereof is smaller than a third threshold $Th_3$. If the latest first residual quantity $W_{r1}$, the latest second residual quantity $W_{r2}$, or the average value or the weighted average value of both thereof is not smaller than the third threshold $Th_3$, it is determined that there is an abnormality in the sublimation gas piping 5 or any branch pipe upstream of the first pressure measuring means 4, and if the latest first residual quantity $W_{r1}$, the latest second residual quantity $W_{r2}$, or the average value or the weighted average value of both thereof is smaller than the third threshold $Th_3$, it is determined that there should be a switch to a different solid material vessel from the abovementioned solid material vessel.

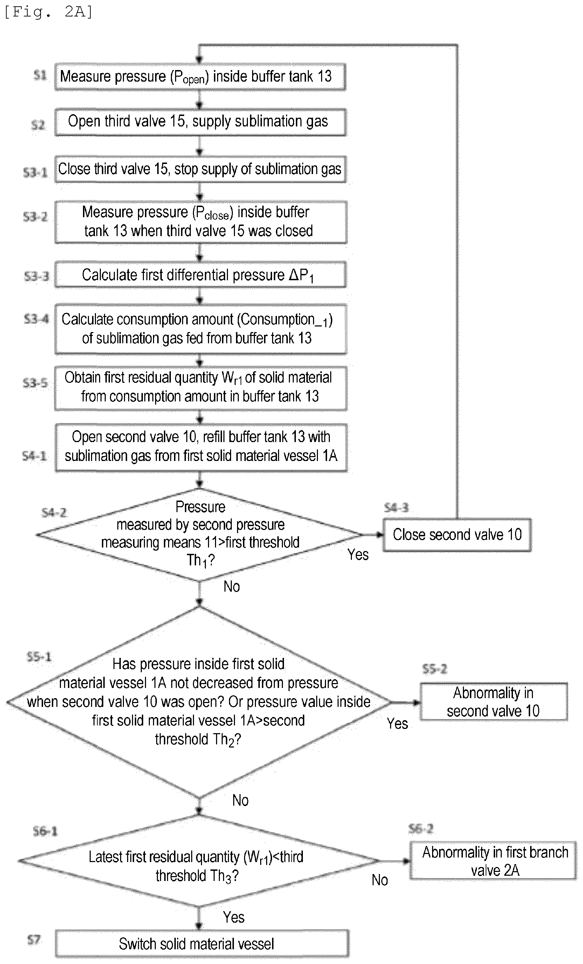

Fig. 2A shows an operating flow of the first sublimation gas supply system. Here, the residual quantity is calculated while focusing on consumption of the sublimation gas inside the buffer tank 13.

(S0) The sublimation gas is fed in advance from the first solid material vessel 1A to the buffer tank 13, and a predetermined gas pressure (>first threshold ($Th_1$)) is maintained. The first branch valve 2A is opened, and the second valve 10 is closed. The second solid material vessel 1B is prepared for switching, and the second branch valve 2B is closed. The third valve 15 is closed.

(S1) The pressure ($P_{open}$) inside the buffer tank 13 before opening of the third valve 15 (For example, "before opening of the third valve 15" means immediately before opening of the third valve 15. It should be noted that "immediately before" means before the sublimation gas supply system receives a signal from the subsequent process and sends an opening signal to the third valve 15 of the sublimation gas supply apparatus.) is measured (measured by the second pressure measuring means 11 when the valve is open). The sublimation gas is fed from the buffer tank 13 to the subsequent process. The pressure ($P_{open}$) may be stored in the memory.

(S2) The third valve 15 is opened. The sublimation gas is supplied to the subsequent process. A time for which the third valve 15 is open is set by means of a request from the subsequent process. The sublimation gas is fed, whereby the pressure inside the buffer tank 13 decreases (measured by the second pressure measuring means 11).

S3 includes S3-1 to S3-5, and S4 includes S4-1 to S4-3.

(S3-1) The third valve 15 is closed. Supply of the sublimation gas is stopped. The time for which the third valve 15 is closed is referred to as downtime. The sublimation gas is fed, whereby the pressure inside the buffer tank 13 decreases (measured by the second pressure measuring means 11).

(S3-1) The pressure ($P_{close}$) inside the buffer tank 13 when the third valve 15 is closed is measured (measured by the second pressure measuring means 11). The pressure ($P_{close}$) may be stored in the memory.

(S3-2) The first differential pressure $\Delta P_1$ is calculated ($\Delta P_1 = P_{open} - P_{close}$). The calculation is performed by means of the first residual quantity calculation unit 21.

(S3-4) The first consumption amount (Consumption $_{-1}$) of the sublimation gas fed from the buffer tank 13 is calculated from the volume $V_{buffer}$ of the buffer tank 13, the first differential pressure $\Delta P_1$, the density d of the sublimation gas, and the first correction factor $C_1$. The calculation is performed by means of the first residual quantity calculation unit 21.

$$\text{Consumption}_{-1} \text{ [kg]} = V_{buffer} \text{ [m}^3\text{]} \times \Delta P_1 \text{ [Pa] } /0.1013 \text{ [MPa]} \times d \text{ [kg/m}^3\text{]} \times C_1 (1) \tag{1}$$

The first correction factor $C_1$ may be omitted. The first correction factor $C_1$ is a factor obtained from verified data after installation of the equipment, and may be selected from a range of 0.8-1.2, for example.

(S3-5) The first consumption amount (Consumption $_{-1}$) calculated in S6 is subtracted from the initial weight $W_0$ of the solid material accommodated in the first solid material vessel 1A. By this means, it is possible to obtain the first residual quantity $W_{r1}$ of the solid material accommodated in the first solid material vessel 1A from the consumption amount in the buffer tank. The calculation is performed by means of the first residual quantity calculation unit 21.

$$\text{First residual quantity } W_{r1} \text{ [kg]} = \text{initial weight } W_0 - \text{Consumption}_{-1} \text{ [kg] (2)} \tag{2}$$

(S4-1) The third valve 15 is closed, after which the second valve 10 is opened. By this means, the sublimation gas is fed from the first solid material vessel 1A to the buffer tank 13.

(S4-2) It is determined whether or not the pressure inside the buffer tank 13 is a first threshold $Th_1$ within a preset period (pressure measured by the second pressure measuring means 11>first threshold $Th_1$).

(S4-3) If the pressure inside the buffer tank 13 exceeds the first threshold $Th_1$, the second valve 10 is closed. By this means, sublimation gas at a predetermined pressure is stored in the buffer tank 13. The sublimation gas can be fed at any time by means of a request from the subsequent process.

The first threshold $Th_1$ is set at a pressure value enabling the sublimation gas to be supplied to the subsequent process, for example.

Steps S1 to S4-2 are repeated.

However, when the subsequent first residual quantity $W_{r1}$ is obtained in S3-5, the first residual quantity $W_{r1}$ obtained immediately before is used instead of the initial weight $W_0$.

$$\text{First residual quantity } W_{r1} \text{ [kg]} = \text{immediately preceding first residual quantity } W_{r1} - \text{Consumption}_{-1} \text{ [kg]}$$

The residual quantity calculation is repeated in the manner described above and is equivalent to the following equation.

$$\text{First residual quantity } W_{r1} \text{ [kg]} = \text{initial weight } W_0 - \Sigma\text{Consumption}_{-1} \text{ [kg] (3)} \tag{3}$$

A method for determining a switching timing and an abnormality from the residual quantity of the solid material inside the solid material vessel will be described in the following steps. In this method, it is determined that a refill limit (empty) of the solid material has been reached in the solid material vessel when a pressure refill of the buffer tank (sublimation gas refill) is not performed in time or cannot be performed while the supply of sublimation gas to the subsequent process is stopped. Cases in which the pressure refill is not performed in time which may be cited include a reduction in the quantity of sublimation gas from the solid material vessel (supply limit level) or an abnormality such as a blockage of a piping line at a valve, etc. There is a risk of the sublimation gas condensing (solidifying) in the piping lines at valves, etc., but the solid material vessels and the piping are heated for supply in this method, so it is possible to prevent erroneous detection caused by this risk.

(S5-1) In S4-2, if the pressure inside the buffer tank 13 does not exceed the first threshold $Th_1$ (i.e., pressure measured by the second pressure measuring means 11 <first threshold $Th_1$) within the preset period (within downtime), it is determined whether or not a pressure value inside the first solid material vessel 1A (pressure measured by the first pressure measuring means 4) has decreased from a pressure value when the second valve 10 was open (during S4-1) (e.g., a predetermined value or more, within values in a predetermined range, or a pressure of 10% or greater or 20% or greater) (i.e., the pressure measured by the first pressure measuring means 4 when the second valve 10 was closed is compared with the pressure measured by the first pressure measuring means 4 when the second valve 10 was open, and it is determined whether or not there has been a decrease), or it is determined whether or not the pressure value inside the first solid material vessel 1A (pressure measured by the first pressure measuring means 4) exceeds the second threshold $Th_2$. The determination is made with the second valve 10 in an open state.

An example of the second threshold $Th_2$ which may be cited is a value where there has been a decrease from an initial internal pressure in the solid material vessel when the buffer tank is refilled with the sublimation gas (initial pressure value measured by the first pressure measuring means 4) by a predetermined value or greater, within values in a predetermined range, or a pressure of 10% or greater or 20% or greater.

(S5-2) In S5-1, if there has been a decrease or the second threshold $Th_2$ is exceeded, it is determined that there is an abnormality in the sublimation gas piping 5 downstream of the first pressure measuring means 4. For example, it is determined that there is an abnormality such as a blockage of the second valve 10.

(S6-1) In S5-1, if there has not been a decrease or the second threshold $Th_2$ is not exceeded, it is determined whether or not the latest first residual quantity $W_{r1}$ obtained in S3 and S4 is smaller than the third threshold $Th_3$. Examples of the third threshold $Th_3$ which may be cited include 8%-12%, 8%-11%, 8%-10%, 8%-9%, 8% or 7% of the initial weight $W_0$.

(S6-2) If the latest (calculated immediately before) first residual quantity $W_{r1}$ is smaller than the third threshold $Th_3$, it is determined that there is an abnormality in the sublimation gas piping 5 or the first branch pipe 3A upstream of the first pressure measuring means 4. For example, it is determined that there is an abnormality such as a blockage of the first branch valve 2A.

(S7) If the latest first residual quantity $W_{r1}$ is smaller than the third threshold $Th_3$, it is determined that a refill limit level has been reached and there is a switch from the first solid material vessel 1A to the second solid material vessel 1B. The first branch valve 2A is closed and the second branch valve 2B is opened. By this means, the sublimation gas is fed from the second solid material vessel 1B to the buffer tank 13.

The first solid material vessel 1A is replaced with a new solid material vessel while sublimation gas is being refilled from the second solid material vessel 1B. Continuous supply is possible by repeating the steps above.

Furthermore, in S6-1, the latest second residual quantity $W_{r2}$ which will be described later may be used for the latest first residual quantity $W_{r1}$, or an average value or a weighted average value of both thereof may be used.

(Different residual quantity measuring method)

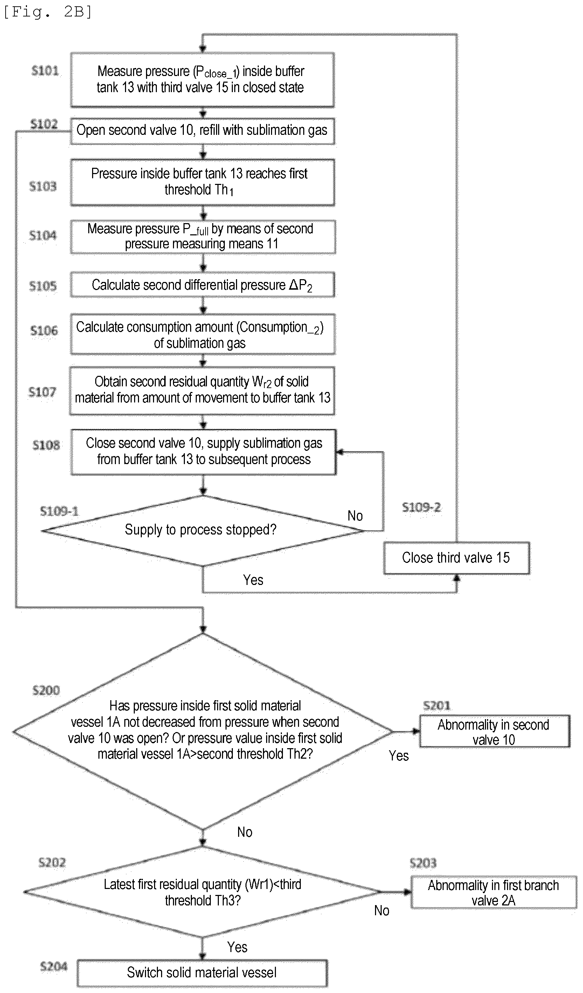

In a different residual quantity measuring method, the residual quantity is calculated while focusing on mass transfer of the sublimation gas from the solid material vessels to the buffer tank 13. Fig. 2B shows an operating flow.

(S100) The first branch valve 2A is opened, and the second valve 10 is closed. The second solid material vessel 1B is prepared for switching, and the second branch valve 2B is closed. The third valve 15 is closed. Here, the sublimation gas may or may not be accommodated inside the buffer tank 13.

(S101) The pressure ($P_{close\_1}$) inside the buffer tank 13 is measured with the third valve 15 in a closed state.

(S102) The second valve 10 is opened. The buffer tank 13 is refilled with the sublimation gas from the first solid material vessel 1A.

(S103) The pressure inside the buffer tank 13 reaches the first threshold $Th_1$ (measured by the second pressure measuring means 11). The second valve 10 is closed and refilling is stopped.

(S104) The pressure $P_{full}$ is measured by the second pressure measuring means 11.

(S105) The second differential pressure $\Delta P_2$ is calculated ($\Delta P_2 = P_{full} - (P_{close\_1})$).

(S106) The second consumption amount (Consumption $_2$) of the sublimation gas fed from the buffer tank 13 is calculated from the volume $V_{buffer}$ of the buffer tank 13, the second differential pressure $\Delta P_2$, the density d of the sublimation gas, and the second correction factor $C_2$.

$$\text{Consumption}_{\_2} \text{ [kg]} = V_{buffer} \text{ [m}^3\text{]} \times \Delta P_2 \text{ [Pa]} /0.1013 \text{ [MPa]} \times d \text{ [kg/m}^3\text{]} \times C_2 \tag{4}$$

The second correction factor $C_2$ may be omitted. The second correction factor $C_2$ is a factor obtained from verified data after installation of the equipment, and may be selected from a range of 0.8-1.2, for example.

(S107) The second consumption amount (Consumption $_2$) calculated in S106 is subtracted from the initial weight $W_0$ of the solid material accommodated in the first solid material vessel 1A. By this means, it is possible to obtain the second residual quantity $W_{r2}$ of the solid material accommodated in the first solid material vessel 1A from the mass transfer to the buffer tank 13.

$$\text{Second residual quantity } W_{r2} \text{ [kg]} = \text{initial weight } W_0 - \text{Consumption}_{\_2} \text{ [kg]} \tag{5}$$

(S108) The second valve 10 is closed, after which the third valve 15 is opened. By this means, the sublimation gas is fed from the buffer tank 13 to the subsequent process. When the supply to the subsequent process is stopped, S101-S108 are repeated during the downtime.

(S109-1) It is determined whether or not the supply to the subsequent process is stopped.

(S 109-2) If the supply is stopped, the third valve 15 is closed.

S101-S108 are repeated during the downtime.

When the subsequent second residual quantity $W_{r2}$ is obtained in S107, the second residual quantity $W_{r2}$ obtained immediately before is used instead of the initial weight $W_0$.

Second residual quantity $W_{r2}$ [kg] = immediately preceding second residual quantity ($W_{r2}$) - Consumption$_2$ [kg]

The residual quantity calculation is repeated in the manner described above and is equivalent to the following equation.

$$\text{Second residual quantity } W_{r2} \text{ [kg]} = \text{initial weight } W_0 - \Sigma\text{Consumption}_2 \text{ [kg]}$$

A method for determining a switching timing and an abnormality from the residual quantity of the solid material inside the solid material vessel will be described next.

(S200) In S102, if the pressure inside the buffer tank 13 does not exceed the first threshold $Th_1$ (pressure measured by the second pressure measuring means 11>first threshold $Th_1$) within the preset period (within downtime), it is determined whether or not the pressure value inside the first solid material vessel 1A (measured by the first pressure measuring means 4) has decreased from the pressure value when the second valve 10 was open (during S102) (e.g., a predetermined value or more, within values in a predetermined range, or a pressure of 10% or greater or 20% or greater) (i.e., the pressure measured by the first pressure measuring means 4 when the second valve 10 was closed is compared with the pressure measured by the first pressure measuring means 4 when the second valve 10 was open, and it is determined whether or not there has been a decrease), or it is determined whether or not the pressure value inside the first solid material vessel 1A (pressure measured by the first pressure measuring means 4) exceeds the second threshold $Th_2$. The determination is made with the second valve 10 in an open state.

(S201) In S200, if there has not been a decrease or the second threshold $Th_2$ is exceeded, it is determined that there is an abnormality in the sublimation gas piping 5 downstream of the first pressure measuring means 4. For example, it is determined that there is an abnormality such as a blockage of the second valve 10.

(S202) In S200, if there has been a decrease or the second threshold $Th_2$ is not exceeded, it is determined whether or not the latest second residual quantity ($W_{r2}$) obtained in S107 is smaller than the third threshold $Th_3$.

(S203) If the latest (calculated immediately before) second residual quantity $W_{r2}$ is not smaller than the third threshold $Th_3$, it is determined that there is an abnormality in the sublimation gas piping 5 or the first branch pipe 3A upstream of the first pressure measuring means 4. For example, it is determined that there is an abnormality such as a blockage of the first branch valve 2A.

(S204) If the latest second residual quantity $W_{r2}$ is smaller than the third threshold $Th_3$, there is a switch from the first solid material vessel 1A to the second solid material vessel 1B. The first branch valve 2A is closed and the second branch valve 2B is opened. By this means, the sublimation gas is fed from the second solid material vessel 1B to the buffer tank 13.

The first solid material vessel 1A is replaced with a new solid material vessel while sublimation gas is being refilled from the second solid material vessel 1B. Continuous supply is possible by repeating the steps above.

Furthermore, in S202, the latest first residual quantity $W_{r1}$ described above may be used for the latest second residual quantity $W_{r2}$, or an average value or a weighted average value of both thereof may be used.

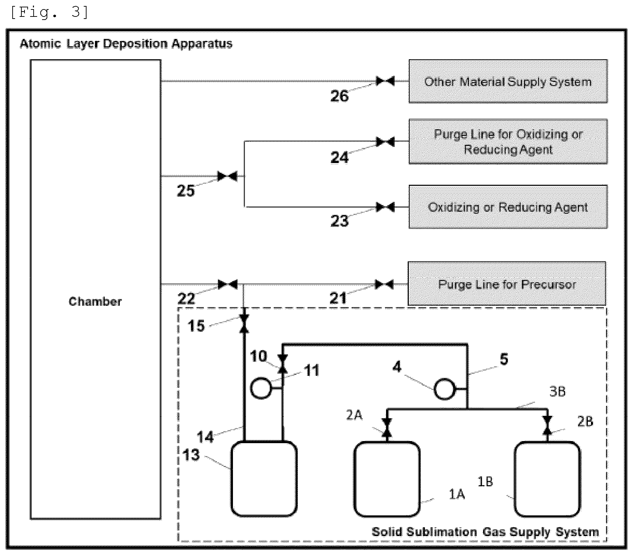

Fig. 3 schematically shows an ALD apparatus incorporating the first sublimation gas supply system.

The ALD apparatus may comprise: the sublimation gas supply system; a chamber (Chamber); a purge line for the sublimation gas (precursor) connected by way of a valve 21 to the introduction pipe 14 connected by way of a valve 22 to the chamber; an oxidizing agent or reducing agent supply portion connected to the chamber by way of valves 23 and 25; an oxidizing agent or reducing agent purge line connected to the chamber by way of valves 24 and 25; and another material supply system connected by way of a valve 26 to the chamber.

(Embodiment 2)

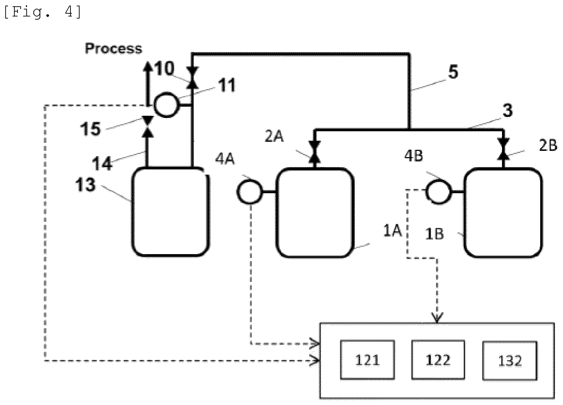

Fig. 4 schematically shows a second sublimation gas supply system. Embodiment 2 differs from embodiment 1 in that, instead of the first pressure measuring means 4, a first sub-pressure measuring means 4A and a second sub-pressure measuring means 4B are directly provided in each of the first solid material vessel 1A and the second solid material vessel 1B. Furthermore, a second switching determination unit 132 is provided instead of the first switching determination unit 131.

When the sublimation gas is fed from either solid material vessel to the buffer tank 13, if the pressure inside the buffer tank 13 does not exceed the first threshold $Th_1$ within the preset period, the second switching determination unit 132 determines whether or not the pressure value inside the solid material vessel has decreased from the pressure value when the second valve 10 was open (e.g., a predetermined value or more, within values in a predetermined range, or a pressure of 10% or greater or 20% or greater) (i.e., the pressure measured by the first pressure measuring means 4 when the second valve 10 was closed is compared with the pressure measured by the first pressure measuring means 4 when the second valve 10 was open, and it is determined whether or not there has been a decrease), or determines whether or not the pressure value inside the solid material vessel exceeds the second threshold $Th_2$. If the pressure value inside the solid material vessel has not decreased from the pressure value when the second valve 10 was open or the pressure value inside the solid material vessel exceeds the second threshold $Th_2$, it is determined that there is an abnormality in the sublimation gas piping 5 downstream of the solid material vessel. If the pressure value inside the solid material vessel has decreased from the pressure value when the second valve 10 was open or the pressure value inside the solid material vessel does not exceed the second threshold $Th_2$, it is determined that there should be a switch to a different solid material vessel from the abovementioned solid material vessel.

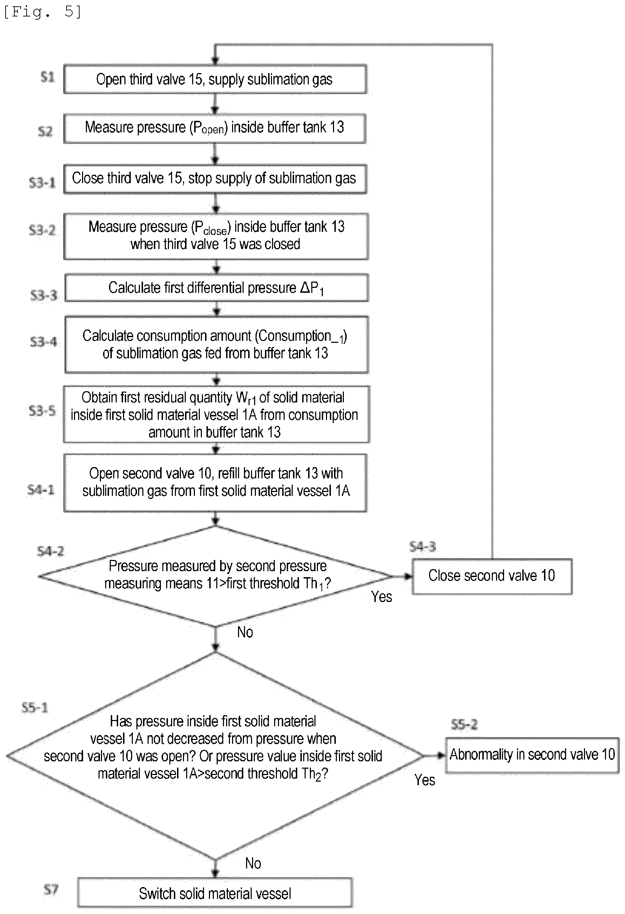

Fig. 5 shows an operating flow. The difference with fig. 2A lies in the fact that steps S6-1 and S6-2 are absent, and the flow transitions to S7 when the result is "No" in S5-1. Furthermore, in terms of the corresponding flow in fig. 2B, the steps S202 and S203 are absent, and the flow transitions to S204 when the result is "No" in step S200, although this is not depicted.

As a different embodiment, the first pressure measuring means 4 may be provided in the sublimation gas piping 5 in the same way as in embodiment 1. This enables the operations of steps S6-1 and S6-2.

(Embodiment 3)

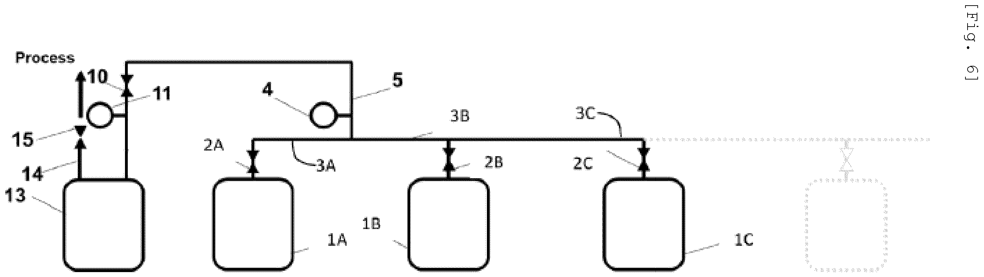

Fig. 6 schematically shows a third sublimation gas supply system. In embodiment 3, a third solid material vessel 1C, a third branch valve 2C, and a third branch pipe 3C are also provided in embodiment 1. It should be noted that fourth and fifth solid material vessels, fourth and fifth branch valves, and fourth and fifth branch pipes may further be provided.

(Embodiment 4)

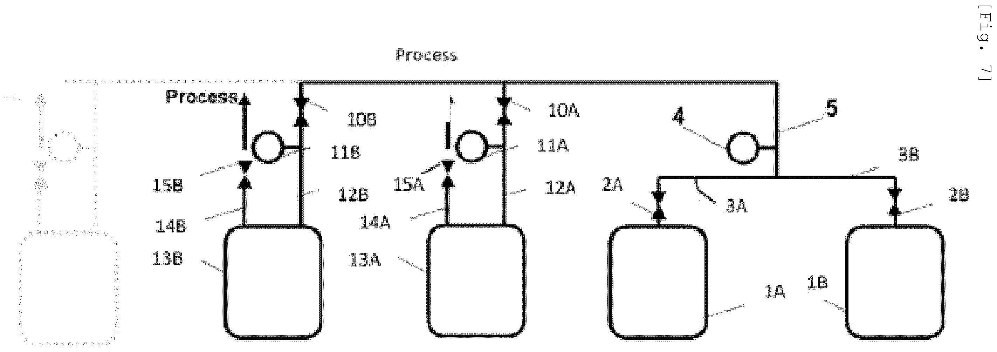

Fig. 7 schematically shows a fourth sublimation gas supply system. Embodiment 4 describes the configuration of embodiment 1 with two buffer tanks, although there may be more than this.

A first sublimation gas branch pipe 12A branching from the sublimation gas piping 5 is connected to a first buffer tank 13A. A first introduction pipe 14A leading out from the first buffer tank 13A is connected to a subsequent first process. A second valve 10A and a second pressure measuring means 11A are provided in the first sublimation gas branch pipe 12A. A third valve 15A is provided in the first introduction pipe 14A.

A second sublimation gas branch pipe 12B branching from the sublimation gas piping 5 is connected to a second buffer tank 13B. A second introduction pipe 14B leading out from the second buffer tank 13B is connected to a subsequent second process. A second valve 10B and a second pressure measuring means 11B are provided in the second sublimation gas branch pipe 12B. A third valve 15B is provided in the second introduction pipe 14B.

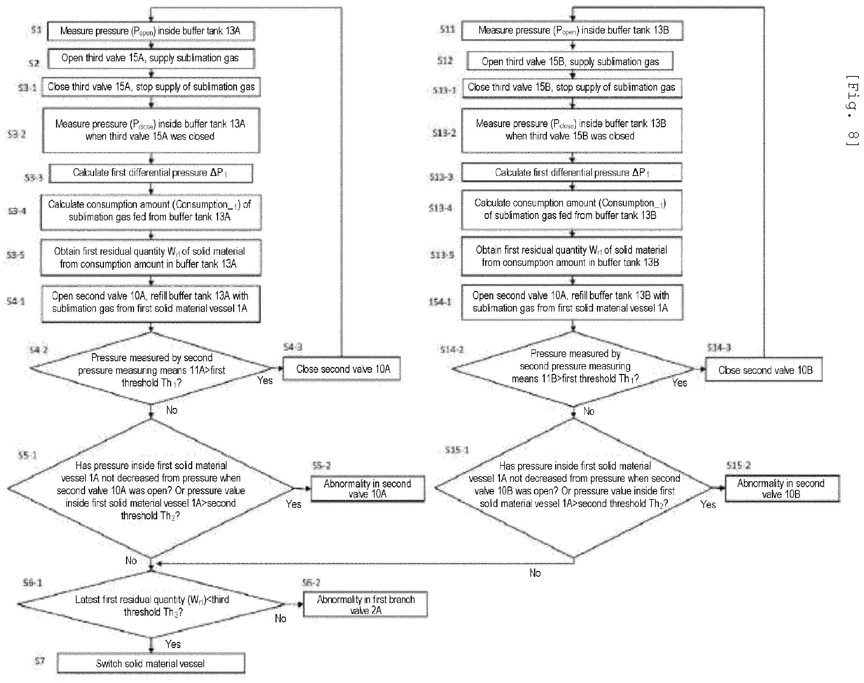

Fig. 8 shows an operating flow of embodiment 4. The difference with fig. 2A lies in the fact that the consumption amount of the sublimation gas when it has been supplied to the subsequent process is calculated and obtained for each of the first buffer tank 13A and the second buffer tank 13B. The operation is substantially the same.

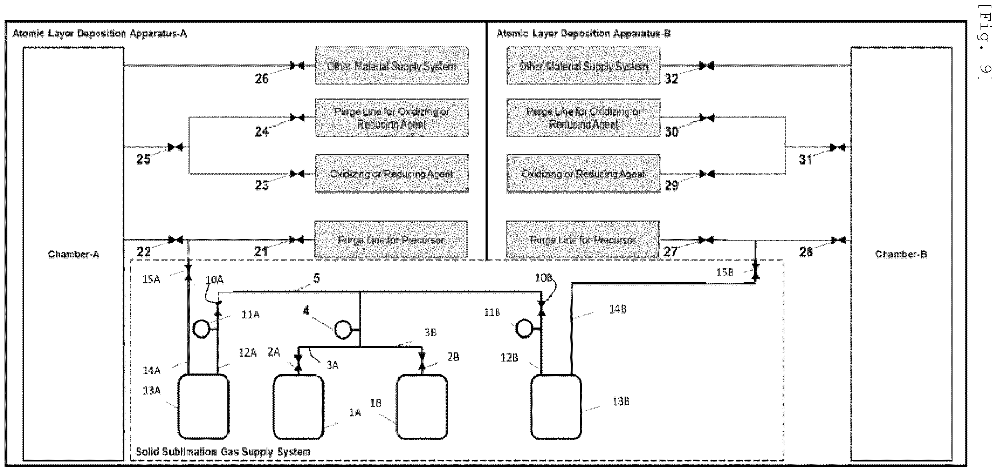

Fig. 9 schematically shows an ALD apparatus A and an ALD apparatus B incorporating a fourth sublimation gas supply system.

The ALD apparatus A may comprise: the fourth sublimation gas supply system; a first chamber (Chamber-A); a purge line for the sublimation gas (precursor) connected by way of a valve 21 to the introduction pipe 14A connected by way of a valve 22 to the first chamber; an oxidizing agent or reducing agent supply portion connected to the first chamber by way of valves 23 and 25; an oxidizing agent or reducing agent purge line connected to the first chamber by way of valves 24 and 25; and another material supply system connected by way of a valve 26 to the first chamber.

Furthermore, the ALD apparatus B may comprise: a second chamber (Chamber-B); a purge line for the sublimation gas (precursor) connected by way of a valve 27 to the introduction pipe 14B connected by way of a valve 28 to the second chamber; an oxidizing agent or reducing agent supply portion connected to the second chamber by way of valves 29 and 31; an oxidizing agent or reducing agent purge line connected to the second chamber by way of valves 30 and 31; and another material supply system connected by way of a valve 32 to the second chamber.

(Embodiment 5)

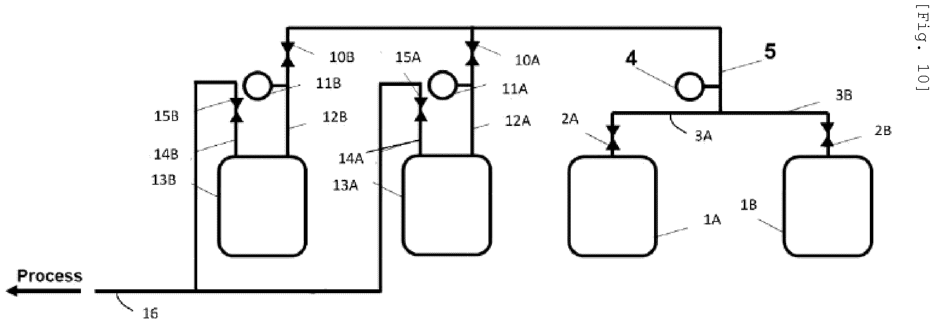

Fig. 10 schematically shows a fifth sublimation gas supply system. Embodiment 5 differs from embodiment 1 in that two buffer tanks are provided, namely first and second buffer tanks 13A, 13B. Additionally, embodiment 5 differs from embodiment 4 in that one introduction pipe 16 is formed by combining the introduction pipes 14A, 14B The introduction pipe 16 is connected to one subsequent process.

The valves 15A, 15B are switched so that either one of the first buffer tank 13A and the second buffer tank 13B can supply the sublimation gas to the subsequent process. For example, when the pressure in the first buffer tank 13A decreases to a predetermined value or less and the sublimation gas can no longer be supplied, the valve 15A is closed and the valve 15B is opened instead so that the sublimation gas is supplied from the second buffer tank 13B.

The first and second buffer tanks 13A, 13B are refilled with the sublimation gas from the first and second solid material vessels in the same way as in embodiment 4. The residual quantity calculation, the determination of a blockage abnormality in the piping and valves, and the determination of substituting the solid material vessel are the same as in embodiment 4.

(Embodiment 6)

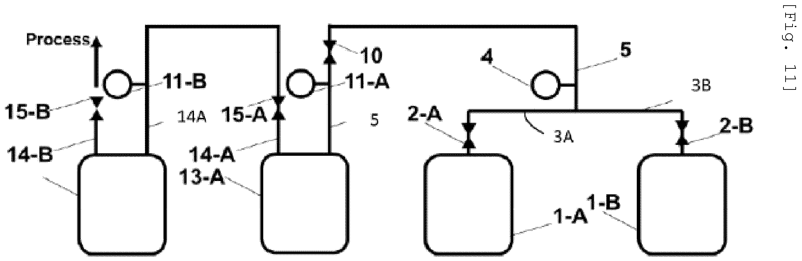

Fig. 11 schematically shows a sixth sublimation gas supply system. This sublimation gas supply system is an example which can be incorporated into a CVD apparatus. Embodiment 6 differs from embodiment 4 (fig. 7) in that the first buffer tank 13A and the second buffer tank 13B are arranged in series.

The sublimation gas piping 5 is connected to the first buffer tank 13A. The first introduction pipe 14A (connecting pipe) leading out from the first buffer tank 13A leads into the subsequent second buffer tank 13B. The second valve 10 and the second pressure measuring means 11A for the first buffer tank are provided in the sublimation gas piping 5. The third valve 15A for the first buffer tank 13A and the second pressure measuring means 11B for the second buffer tank are provided in the first introduction pipe 14A (connecting pipe). The second introduction pipe 14B leading out from the second buffer tank 13B is connected to the subsequent process. The third valve 15B for the second buffer tank is provided in the second introduction pipe 14B.

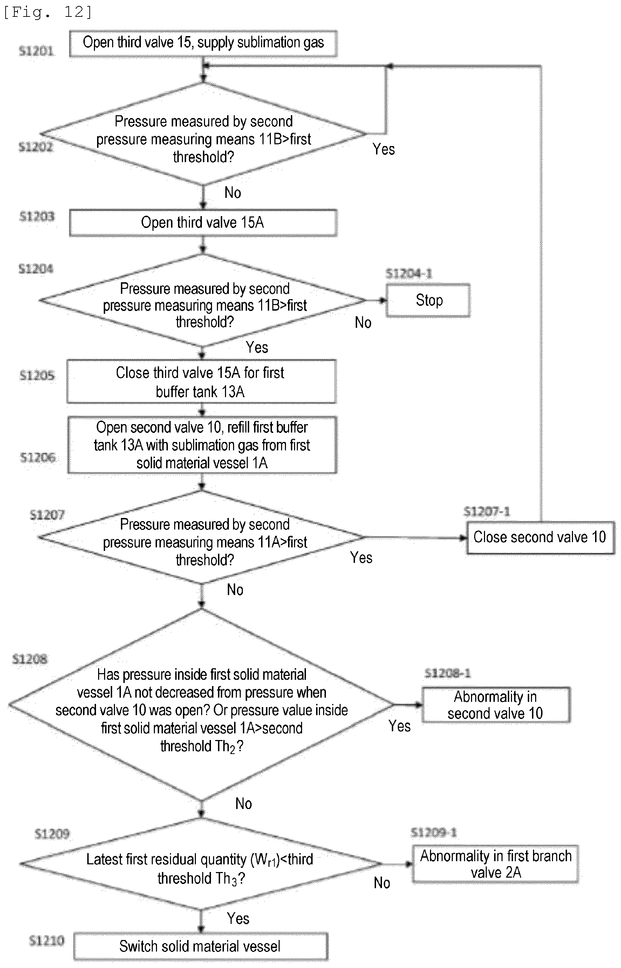

Fig. 12 shows an operating flow of embodiment 6. The second valve 10 and the third valve 15A for the first buffer tank 13A are in a closed state.

(S1201) The third valve 15B for the second buffer tank opens from a closed state. The sublimation gas is supplied to the subsequent process.

(S1202) It is determined whether or not the pressure value measured by the second pressure measuring means 11B for the second buffer tank exceeds the first threshold $Th_1$. This determination is repeated while the pressure value exceeds said threshold.

(S1203) If the pressure value does not exceed the first threshold $Th_1$, the third valve 15A for the first buffer tank 13A is opened. The supply to the subsequent process is continued.

(S1204) It is determined whether or not the pressure value measured by the second pressure measuring means 11B for the second buffer tank exceeds the first threshold $Th_1$ during the preset period.

(S1204-1) If the pressure value does not exceed said threshold, the third valve 15B for the second buffer tank is closed. The supply to the subsequent process is stopped.

(S1205) If the pressure value exceeds said threshold, the third valve 15A for the first buffer tank 13A is closed.

(S1206) The second valve 10 is then opened. The first buffer tank 13A is refilled with the sublimation gas from the first solid material vessel 1A.

(S1207) It is determined whether or not the pressure measured by the second pressure measuring means 11A for the second buffer tank exceeds the first threshold $Th_1$.

(S1207-1) If the pressure value exceeds said threshold, the second valve 10 is closed. The flow then returns to S1202.

(S1208) It is determined whether or not the pressure inside the first solid material vessel 1A has not decreased from the pressure when the second valve 10 was open or whether or not the pressure value inside the first solid material vessel 1A exceeds the second threshold $Th_2$. This is the same operation as in S5-1 or S200.

(S1208-1) If the pressure has not decreased or if the pressure value exceeds the second threshold, it is determined that there is an abnormality in the second valve 10. This is the same operation as in S5-2 or S201.

(S1209) It is determined whether or not the latest first residual quantity ($W_{r1}$) is less than the third threshold $Th_3$. This is the same operation as in S6-1 or S202.

(S1209-1) If the latest first residual quantity $W_{r1}$ is not less than the third threshold Th3, it is determined that there is an abnormality such as a blockage of the first branch valve 2A upstream of the first pressure measuring means 4. This is the same operation as in S6-2 or S203.

(S1210) If the latest first residual quantity $W_{r1}$ is smaller than the third threshold $Th_3$, it is determined that the refill limit level has been reached and there is a switch from the first solid material vessel 1A to the second solid material vessel 1B. This is the same operation as in S7 or S204.

The calculations of the first consumption amount (Consumption$_{\_1}$) and the first residual quantity $W_{r1}$ are carried

out in the same way as in embodiment 1 in embodiment 6 also.

(Other embodiments)

(1) In embodiments 1-5, the valves provided in the piping are not limited to the positions depicted, and the number of valves is not limited either.
(2) The valves may be gate valves or flow rate regulating valves.
(3) A mass flow controller, mass flow meter and a thermometer, etc. may be provided in the piping.
(4) The sublimation gas supply systems of embodiments 1-5 may be incorporated into any of an ALD apparatus, a CVD apparatus, and an etching apparatus.

Many improvements to and other embodiments of the present disclosure will be apparent from the descriptions above to those skilled in the art. The descriptions above should therefore be viewed merely as examples provided for the purpose of teaching those skilled in the art the best way of implementing the present disclosure. The details of the structure and/or function may be substantially modified without departing from the essence of the present disclosure.

[Key to Symbols]

| | |
|---|---|
| 1 | Sublimation gas supply system |
| 1A | First solid material vessel |
| 1B | Second solid material vessel |
| 2A | First branch valve |
| 2B | Second branch valve |
| 3A | First branch pipe |
| 3B | Second branch pipe |
| 4 | First pressure measuring means |
| 5 | Sublimation gas piping |
| 10 | Second valve |
| 11 | Second pressure measuring means |
| 12 | Buffer tank introduction pipe |
| 14 | Introduction pipe |
| 15 | Third valve |
| 121 | First residual quantity calculation unit |
| 122 | Second residual quantity calculation unit |
| 131 | First switching determination unit |
| 132 | Second switching determination unit |

**Claims**

1. A sublimation supply method comprising:

a supply step in which a sublimation gas is supplied from a buffer tank to a subsequent process;
a supply stop step in which the supply of the sublimation gas from the buffer tank to the subsequent process is stopped; and
a sublimation gas refill step in which the buffer tank is refilled with the sublimation gas during the supply stop step, the sublimation gas refill step comprising:

a first residual quantity calculation step in which a residual quantity of the solid material is calculated from a consumption amount of the sublimation gas fed from the buffer tank to the subsequent process;
a second residual quantity calculation step in which the residual quantity of the solid material is calculated from a mass amount of the sublimation gas fed from a solid material vessel to the buffer tank; and/or
a switching determination step in which a switching timing and an abnormality are determined from the residual quantity of the solid material inside the solid material vessel.

2. The sublimation gas supply method as claimed in claim 1, wherein, in the first residual quantity calculation step:

a first consumption amount (Consumption $_1$) of the sublimation gas fed from the buffer tank is calculated from: a first differential pressure $\Delta P_1$ between a pressure ($P_{open}$) inside the buffer tank before opening of a third valve for feeding to the subsequent process in a state in which the sublimation gas is stored in the buffer tank, and a pressure ($P_{close}$) inside the buffer tank when the third valve has been closed after the sublimation gas has been fed from the buffer tank to the subsequent process, the volume ($V_{buffer}$) of the buffer tank, the density (d) of the sublimation gas, and a first correction factor ($C_1$); and a first residual quantity ($W_{r1}$) of the solid material accommodated in the solid material vessel is calculated by subtracting the total quantity of the calculated first consumption amount (Consumption $_1$) from an initial weight ($W_0$) of the solid material accommodated in the solid material vessel currently supplying the sublimation gas to the buffer tank.

3. The sublimation gas supply method as claimed in claim 1 or 2, wherein, in the second residual quantity calculation step:

a second consumption amount (Consumption $_2$) of the sublimation gas fed from the buffer tank is calculated from: a second differential pressure $\Delta P_2$ between a pressure ($P_{close\_1}$) inside the buffer tank in a state in which the valve for feeding to the subsequent process is closed, and a pressure ($P_{full}$) when the sublimation gas has been fed to the buffer tank from any solid material vessel and the pressure inside the buffer tank has reached a set pressure, the volume ($V_{buffer}$) of the buffer tank, the density (d) of the sublimation gas, and a second correction factor ($C_2$); and a second residual quantity ($W_{r\,2}$) of the solid material accommodated in the solid material vessel is calculated by subtracting the total quantity of the calculated second consumption amount (Consumption $_2$) from an initial weight ($W_0$) of the solid material accommodated in the solid material vessel currently supplying the sublimation gas to the buffer tank.

4. The sublimation gas supply method as claimed in any one of claims 1 to 3, wherein, in the switching determination step:

when the sublimation gas is fed from any solid material vessel to the buffer tank, if the pressure inside the buffer tank does not exceed a first threshold ($Th_1$) within a preset period, it is determined whether or not a pressure value inside the solid material vessel has decreased from a pressure value when a second valve, which is arranged between a first pressure measuring means and a second pressure measuring means, was open, or it is determined whether or not the pressure value inside the solid material vessel exceeds a second threshold ($Th_2$), and if the pressure value has not decreased or exceeds the second threshold ($Th_2$), it is determined that there is an abnormality in sublimation gas piping downstream of the first pressure measuring means, and if the pressure value has decreased or does not exceed the second threshold ($Th_2$), it is determined whether or not a latest first residual quantity ($W_{r\,1}$), a latest second residual quantity ($W_{r\,2}$), or an average value or a weighted average value of both thereof is smaller than a third threshold ($Th_3$), and if the latest first residual quantity ($W_{r\,1}$), the latest second residual quantity ($W_{r\,2}$), or the average value or the weighted average value of both thereof is not smaller than the third threshold ($Th_3$), it is determined that there is an abnormality in the sublimation gas piping or any branch pipe upstream of the first pressure measuring means, and if the latest first residual quantity ($W_{r\,1}$), the latest second residual quantity ($W_{r\,2}$), or the average value or the weighted average value of both thereof is smaller than the third threshold ($Th_3$), it is determined that there should be a switch to a different solid material vessel from the abovementioned solid material vessel; or
when the sublimation gas is fed from any solid material vessel to the buffer tank, if the pressure inside the buffer tank does not exceed a first threshold ($Th_1$) within a preset period, it is determined whether or not a pressure value inside the solid material vessel has decreased from a pressure value when a second valve, which is arranged between a first pressure measuring means and a second pressure measuring means, was open, or it is determined whether or not the pressure value inside the solid material vessel exceeds a second threshold ($Th_2$), and if the pressure value has not decreased or exceeds the second threshold ($Th_2$), it is determined that there is an abnormality in a branch pipe or
sublimation gas piping downstream of the solid material vessel, and if the pressure value has decreased or does not exceed the second threshold ($Th_2$), it is determined that there should be a switch to a different solid material vessel from the abovementioned solid material vessel.

5. A sublimation gas supply system comprising:

at least two solid material vessels in which a solid material is accommodated;
sublimation gas piping which is formed by merging of branch pipes leading out from each of the solid material vessels;

at least one buffer tank connected to the sublimation gas piping;

at least one introduction pipe for introducing the sublimation gas from the at least one buffer tank to at least one subsequent process;

a first pressure measuring means provided in the sublimation gas piping or each branch pipe;

a first valve provided between the solid material vessels and the first pressure measuring means, or branch valves provided in each branch pipe;

at least one second valve provided between the first pressure measuring means and the at least one buffer tank or in each branch pipe branching from the sublimation gas piping to each buffer tank;

at least one third valve provided in the introduction pipe; and

a second pressure measuring means provided between the second valve and the third valve,

wherein the sublimation gas supply system further comprises: a first residual quantity calculation unit for calculating a residual quantity of the solid material from a consumption amount of the sublimation gas fed from the buffer tank to the subsequent process;

a second residual quantity calculation unit for calculating the residual quantity of the solid material from a mass amount of the sublimation gas fed from the solid material vessel to the buffer tank; and/or

a first switching determination unit for determining a switching timing and an abnormality from the residual quantity of the solid material inside the solid material vessel.

6. A sublimation gas supply system comprising:

at least two solid material vessels in which a solid material is accommodated;

sublimation gas piping which is formed by merging of branch pipes leading out from each of the solid material vessels;

at least one buffer tank connected to the sublimation gas piping;

at least one introduction pipe for introducing the sublimation gas from the at least one buffer tank to at least one subsequent process;

a first pressure measuring means provided in each of the solid material vessels;

branch valves provided in each branch pipe running to the sublimation gas piping;

at least one second valve provided between the first pressure measuring means and the at least one buffer tank or in each branch pipe branching from the sublimation gas piping to each buffer tank;

at least one third valve provided in the introduction pipe; and

a second pressure measuring means provided between the second valve and the third valve,

wherein the sublimation gas supply system further comprises: a first residual quantity calculation unit for calculating a residual quantity of the solid material from a consumption amount of the sublimation gas fed from the buffer tank to the subsequent process;

a second residual quantity calculation unit for calculating the residual quantity of the solid material from a mass amount of the sublimation gas fed from the solid material vessel to the buffer tank; and/or

a second switching determination unit for determining a switching timing and an abnormality from the residual quantity of the solid material inside the solid material vessel.

7. The sublimation gas supply system as claimed in claim 6, wherein the first residual quantity calculation unit: calculates a first consumption amount ($Consumption_1$) of the sublimation gas fed from the buffer tank from: a first differential pressure $\Delta P_1$ between a pressure ($P_{open}$) inside the buffer tank before opening of the third valve in a state in which the sublimation gas is stored in the buffer tank, and a pressure ($P_{close}$) inside the buffer tank when the third valve has been closed after the sublimation gas has been fed from the buffer tank to the subsequent process, the volume ($V_{buffer}$) of the buffer tank, the density (d) of the sublimation gas, and a first correction factor ($C_1$); and calculates a first residual quantity ($W_{r1}$) of the solid material accommodated in the solid material vessel by subtracting the total quantity of the calculated first consumption amount ($Consumption_1$) from an initial weight ($W_0$) of the solid material accommodated in the solid material vessel currently supplying the sublimation gas to the buffer tank.

8. The sublimation gas supply system as claimed in claim 6 or 7, wherein the second residual quantity calculation unit: calculates a second consumption amount ($Consumption_2$) of the sublimation gas fed from the buffer tank from: a second differential pressure $\Delta P_2$ between a pressure ($P_{close\_1}$) inside the buffer tank in a state in which the third valve is closed, and a pressure ($P_{full}$) when the sublimation gas has been fed to the buffer tank from any solid material vessel and the pressure inside the buffer tank has reached a set pressure, the volume ($V_{buffer}$) of the buffer tank, the density (d) of the sublimation gas, and a second correction factor ($C_2$); and calculates a second residual quantity ($W_{r2}$) of the solid material accommodated in the solid material vessel by subtracting the total quantity of the calculated second consumption amount (Consumption $_2$) from an initial weight ($W_0$) of the solid material accommodated in the solid material vessel currently supplying the sublimation gas to the buffer tank.

9. The sublimation gas supply system as claimed in claim 6, wherein the first switching determination unit: when the sublimation gas is fed from any solid material vessel to the buffer tank, if the pressure inside the buffer tank does not exceed a first threshold ($Th_1$) within a preset period, determines whether or not a pressure value inside the solid material vessel has decreased from a pressure value when a second valve, which is arranged between a first pressure measuring means and a second pressure measuring means, was open, or determines whether or not the pressure value inside the solid material vessel exceeds a second threshold ($Th_2$), and if the pressure value has not decreased or exceeds the second threshold ($Th_2$), determines that there is an abnormality in sublimation gas piping downstream of the first pressure measuring means, and if the pressure value has decreased or does not exceed the second threshold ($Th_2$), determines whether or not a latest first residual quantity ($W_{r\,1}$), a latest second residual quantity ($W_{r\,2}$), or an average value or a weighted average value of both thereof is smaller than a third threshold ($Th_3$), and if the latest first residual quantity ($W_{r\,1}$), the latest second residual quantity ($W_{r\,2}$), or the average value or the weighted average value of both thereof is not smaller than the third threshold ($Th_3$), determines that there is an abnormality in the sublimation gas piping or any branch pipe upstream of the first pressure measuring means, and if the latest first residual quantity ($W_{r\,1}$), the latest second residual quantity ($W_{r\,2}$), or the average value or the weighted average value of both thereof is smaller than the third threshold ($Th_3$), determines that there should be a switch to a different solid material vessel from the abovementioned solid material vessel.

10. The sublimation gas supply system as claimed in claim 7, wherein the second switching determination unit: when the sublimation gas is fed from any solid material vessel to the buffer tank, if the pressure inside the buffer tank does not exceed a first threshold ($Th_1$) within a preset period, it is determined whether or not a pressure value inside the solid material vessel has decreased from a pressure value when a second valve, which is arranged between a first pressure measuring means and a second pressure measuring means, was open, or it is determined whether or not the pressure value inside the solid material vessel exceeds a second threshold ($Th_2$), and if the pressure value has not decreased or exceeds the second threshold ($Th_2$), it is determined that there is an abnormality in a branch pipe or sublimation gas piping downstream of the solid material vessel, and if the pressure value has decreased or does not exceed the second threshold ($Th_2$), it is determined that there should be a switch to a different solid material vessel from the abovementioned solid material vessel.

11. A residual quantity measuring method for measuring a residual quantity of a solid material inside a solid material vessel, the residual quantity measuring method comprises, when a buffer tank is refilled with a sublimation gas:

   a first residual quantity calculation step in which a residual quantity of the solid material is calculated from a consumption amount of the sublimation gas fed from the buffer tank to the subsequent process;
   a second residual quantity calculation step in which the residual quantity of the solid material is calculated from a mass amount of the sublimation gas fed from a solid material vessel to the buffer tank; and/or
   a switching determination step in which a switching timing and an abnormality are determined from the residual quantity of the solid material inside the solid material vessel.

[Fig. 1]

[Fig. 2A]

S1 — Measure pressure ($P_{open}$) inside buffer tank 13

S2 — Open third valve 15, supply sublimation gas

S3-1 — Close third valve 15, stop supply of sublimation gas

S3-2 — Measure pressure ($P_{close}$) inside buffer tank 13 when third valve 15 was closed

S3-3 — Calculate first differential pressure $\Delta P_1$

S3-4 — Calculate consumption amount ($Consumption_{-1}$) of sublimation gas fed from buffer tank 13

S3-5 — Obtain first residual quantity $W_{r1}$ of solid material from consumption amount in buffer tank 13

S4-1 — Open second valve 10, refill buffer tank 13 with sublimation gas from first solid material vessel 1A

S4-2 — Pressure measured by second pressure measuring means 11>first threshold $Th_1$?

S4-3 — Close second valve 10 — Yes

No

S5-1 — Has pressure inside first solid material vessel 1A not decreased from pressure when second valve 10 was open? Or pressure value inside first solid material vessel 1A>second threshold $Th_2$?

S5-2 — Abnormality in second valve 10 — Yes

No

S6-1 — Latest first residual quantity ($W_{r1}$)<third threshold $Th_3$?

S6-2 — Abnormality in first branch valve 2A — No

Yes

S7 — Switch solid material vessel

[Fig. 2B]

S101    Measure pressure ($P_{close\_1}$) inside buffer tank 13 with third valve 15 in closed state

S102    Open second valve 10, refill with sublimation gas

S103    Pressure inside buffer tank 13 reaches first threshold $Th_1$

S104    Measure pressure $P\_full$ by means of second pressure measuring means 11

S105    Calculate second differential pressure $\Delta P_2$

S106    Calculate consumption amount ($Consumption\_2$) of sublimation gas

S107    Obtain second residual quantity $W_{r2}$ of solid material from amount of movement to buffer tank 13

S108    Close second valve 10, supply sublimation gas from buffer tank 13 to subsequent process

S109-1    Supply to process stopped?    No    S109-2

Close third valve 15

Yes

S200    Has pressure inside first solid material vessel 1A not decreased from pressure when second valve 10 was open? Or pressure value inside first solid material vessel 1A>second threshold Th2?    Yes    S201    Abnormality in second valve 10

No

S202    Latest first residual quantity (Wr1)<third threshold Th3?    No    S203    Abnormality in first branch valve 2A

Yes

S204    Switch solid material vessel

EP 4 467 683 A1

[Fig. 3]

**Atomic Layer Deposition Apparatus**

Other Material Supply System

26

Purge Line for Oxidizing or Reducing Agent

24

Oxidizing or Reducing Agent

23

25

Chamber

22

Purge Line for Precursor

21

15

10    11

4       5

3B

2A        2B

14

13

1A    1B

Solid Sublimation Gas Supply System

22

[Fig. 4]

[Fig. 5]

S1 — Open third valve 15, supply sublimation gas

S2 — Measure pressure ($P_{open}$) inside buffer tank 13

S3-1 — Close third valve 15, stop supply of sublimation gas

S3-2 — Measure pressure ($P_{close}$) inside buffer tank 13 when third valve 15 was closed

S3-3 — Calculate first differential pressure $\Delta P_1$

S3-4 — Calculate consumption amount (Consumption$_{-1}$) of sublimation gas fed from buffer tank 13

S3-5 — Obtain first residual quantity $W_{r1}$ of solid material inside first solid material vessel 1A from consumption amount in buffer tank 13

S4-1 — Open second valve 10, refill buffer tank 13 with sublimation gas from first solid material vessel 1A

S4-2 — Pressure measured by second pressure measuring means 11>first threshold $Th_1$?

Yes → S4-3 — Close second valve 10

No ↓

S5-1 — Has pressure inside first solid material vessel 1A not decreased from pressure when second valve 10 was open? Or pressure value inside first solid material vessel 1A>second threshold $Th_2$?

Yes → S5-2 — Abnormality in second valve 10

No ↓

S7 — Switch solid material vessel

[Fig. 6]

[Fig. 7]

EP 4 467 683 A1

EP 4 467 683 A1

[Fig. 8]

**S1** Measure pressure ($P_{open}$) inside buffer tank 13A

**S2** Open third valve 15A, supply sublimation gas

**S3-1** Close third valve 15A, stop supply of sublimation gas

**S3-2** Measure pressure ($P_{close}$) inside buffer tank 13A when third valve 15A was closed

**S3-3** Calculate first differential pressure $\Delta P_1$

**S3-4** Calculate consumption amount (Consumption_$_1$) of sublimation gas fed from buffer tank 13A

**S3-5** Obtain first residual quantity $W_{r1}$ of solid material from consumption amount in buffer tank 13A

**S4-1** Open second valve 10A, refill buffer tank 13A with sublimation gas from first solid material vessel 1A

**S4-2** Pressure measured by second pressure measuring means 11A>first threshold $Th_1$? — Yes → **S4-3** Close second valve 10A

No ↓

**S5-1** Has pressure inside first solid material vessel 1A not decreased from pressure when second valve 10A was open? Or pressure value inside first solid material vessel 1A>second threshold $Th_2$? — Yes → **S5-2** Abnormality in second valve 10A

No ↓

**S6-1** Latest first residual quantity ($W_{r1}$)<third threshold $Th_3$? — No → **S6-2** Abnormality in first branch valve 2A

Yes ↓

**S7** Switch solid material vessel

---

**S11** Measure pressure ($P_{open}$) inside buffer tank 13B

**S12** Open third valve 15B, supply sublimation gas

**S13-1** Close third valve 15B, stop supply of sublimation gas

**S13-2** Measure pressure ($P_{close}$) inside buffer tank 13B when third valve 15B was closed

**S13-3** Calculate first differential pressure $\Delta P_1$

**S13-4** Calculate consumption amount (Consumption_$_1$) of sublimation gas fed from buffer tank 13B

**S13-5** Obtain first residual quantity $W_{r1}$ of solid material from consumption amount in buffer tank 13B

**S14-1** Open second valve 10A, refill buffer tank 13B with sublimation gas from first solid material vessel 1A

**S14-2** Pressure measured by second pressure measuring means 11B>first threshold $Th_1$? — Yes → **S14-3** Close second valve 10B

No ↓

**S15-1** Has pressure inside first solid material vessel 1A not decreased from pressure when second valve 10B was open? Or pressure value inside first solid material vessel 1A>second threshold $Th_2$? — Yes → **S15-2** Abnormality in second valve 10B

No →

[Fig. 9]

[Fig. 10]

[Fig. 11]

# EP 4 467 683 A1

[Fig. 12]

```
S1201 ─── Open third valve 15, supply sublimation gas

S1202 ─── Pressure measured by second
          pressure measuring means 11B>first
          threshold?
                                          Yes

          No

S1203 ─── Open third valve 15A

S1204 ─── Pressure measured by second        S1204-1
          pressure measuring means 11B>first    Stop
          threshold?
                              No
          Yes

S1205 ─── Close third valve 15A for first
          buffer tank 13A

S1206 ─── Open second valve 10, refill first buffer
          tank 13A with sublimation gas from first
          solid material vessel 1A

S1207 ─── Pressure measured by second               S1207-1
          pressure measuring means 11A>first      Close second valve 10
          threshold?
                                        Yes
          No

S1208 ─── Has pressure inside first solid material      S1208-1
          vessel 1A not decreased from pressure when    Abnormality in
          second valve 10 was open? Or pressure value inside  second valve 10
          first solid material vessel 1A>second
          threshold Th₂?                    Yes
          No

S1209 ─── Latest first residual quantity (W_r1)<third    S1209-1
          threshold Th₃?                        Abnormality in first branch
                                                valve 2A
                                          No
          Yes

S1210 ─── Switch solid material vessel
```

31

<table>
<tr><td colspan="2">**INTERNATIONAL SEARCH REPORT**</td><td>International application No.<br>**PCT/JP2023/000987**</td></tr>
</table>

**A. CLASSIFICATION OF SUBJECT MATTER**

*C23C 16/448*(2006.01)i; *B01J 4/00*(2006.01)i; *B01J 7/00*(2006.01)i; *H01L 21/205*(2006.01)i
FI: C23C16/448; B01J4/00 102; B01J7/00 Z; H01L21/205

According to International Patent Classification (IPC) or to both national classification and IPC

**B. FIELDS SEARCHED**

Minimum documentation searched (classification system followed by classification symbols)

C23C16/448; B01J4/00; B01J7/00; H01L21/205

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2021-42445 A (TOKYO ELECTRON LTD.) 18 March 2021 (2021-03-18)<br>entire text, all drawings | 1-11 |
| A | JP 2017-66511 A (TOKYO ELECTRON LTD.) 06 April 2017 (2017-04-06)<br>entire text, all drawings | 1-11 |
| A | JP 2020-149180 A (HORIBA STEC, CO., LTD.) 17 September 2020 (2020-09-17)<br>entire text, all drawings | 1-11 |

☐ Further documents are listed in the continuation of Box C.   ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **23 March 2023** | **04 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/000987**

| Patent document cited in search report | | | Publication date (day/month/year) | Patent family member(s) | | | Publication date (day/month/year) |
|---|---|---|---|---|---|---|---|
| JP | 2021-42445 | A | 18 March 2021 | (Family: none) | | | |
| JP | 2017-66511 | A | 06 April 2017 | US | 2017/0092549 | A1 | |
| | | | | KR | 10-2017-0038730 | A | |
| | | | | CN | 107043927 | A | |
| | | | | TW | 201726968 | A | |
| JP | 2020-149180 | A | 17 September 2020 | US | 2020/0294820 | A1 | |
| | | | | KR | 10-2020-0109252 | A | |
| | | | | CN | 111690909 | A | |
| | | | | TW | 202033910 | A | |

Form PCT/ISA/210 (patent family annex) (January 2015)

33

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H3141192 A

- WO 2021067764 A1